Europäisches Patentamt

European Patent Office

Office européen des brevets

(19)

(11) **EP 1 557 948 A1**

(12) # EUROPEAN PATENT APPLICATION

(43) Date of publication:
**27.07.2005 Bulletin 2005/30**

(51) Int Cl.⁷: **H03K 17/041**, H03K 17/0412

(21) Application number: **04017410.4**

(22) Date of filing: **22.07.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **23.01.2004 US 763664**

(71) Applicant: **Hewlett-Packard Development Company, L.P.
Houston, TX 77070 (US)**

(72) Inventor: **Hirst, Mark
Boise, ID 83713 (US)**

(74) Representative: **Schoppe, Fritz, Dipl.-Ing. et al
Schoppe, Zimmermann, Stöckeler & Zinkler
Patentanwälte
Postfach 246
82043 Pullach bei München (DE)**

(54) **Alternating current switching circuit**

(57)     An alternating current (AC) switching circuit comprises a first Field Effect Transistor (FET) (144, 244) having a first source, a first gate and a first drain and a second FET (142,242) having a second drain, a second source coupled to the first source and a second gate coupled to the first gate. The AC switching circuit also comprises a first diode (112, 232) coupled to the first source and first drain and a second diode (114, 234) coupled to the second source and second drain.

FIG. 1

**Description**

BACKGROUND

Alternating Current (AC) power control provides a unique set of challenges to those working in the field. There are few solid state electrical devices, such as thyristors and triacs, that will allow AC power to be controlled directly. For both thyristor and triacs the switching times are comparatively long. These long switching times typically limit these devices to low frequency applications, typically AC frequencies of 50-60 Hz. Additionally, full wave rectification to convert AC to direct current (DC), to facilitate work with DC, can result in, among other things, undesirable current harmonics and high frequency conducted emissions that, if not filtered, result in unacceptable noise going back to the power company on the AC power supply lines.

BRIEF DESCRIPTION OF THE DRAWINGS

Embodiments of the present invention will be described referencing the accompanying drawings in which like references denote similar elements, and in which:

FIG. 1        illustrates an AC MOSFET switch, including anti-parallel diodes, in accordance with one embodiment.
FIG. 2        illustrates a more detailed look at an AC MOSFET switch, including intrinsic parasitic diodes of the MOSFETs, in accordance with one embodiment.
FIG. 3        illustrates current that is delivered to a load when one embodiment of the AC MOSFET switch is utilized to control current.
FIGs. 4A-4C   illustrate a power filter and its effects on the current drawn by a load driven by an AC MOSFET switch, in accordance with one embodiment.
FIG. 5        illustrates an AC MOSFET switch design including a snubbing device, in accordance with one embodiment.
FIG. 6        illustrates a single IC device containing two NMOS type MOSFET devices of an AC MOSFET switch, in accordance with one embodiment.

DETAILED DESCRIPTION OF EMBODIMENTS

Although specific embodiments will be illustrated and described herein, it will be appreciated by those of ordinary skill in the art that a wide variety of alternate and/or equivalent implementations may be substituted for the specific embodiments shown and described without departing from the scope of the present invention. This application is intended to cover any adaptations or variations of the embodiments discussed herein. Therefore, it is manifestly intended that this invention be limited only by the claims.

The following discussion is presented in the context of MOSFET devices. It is understood that the principles described herein may apply to other transistor devices.

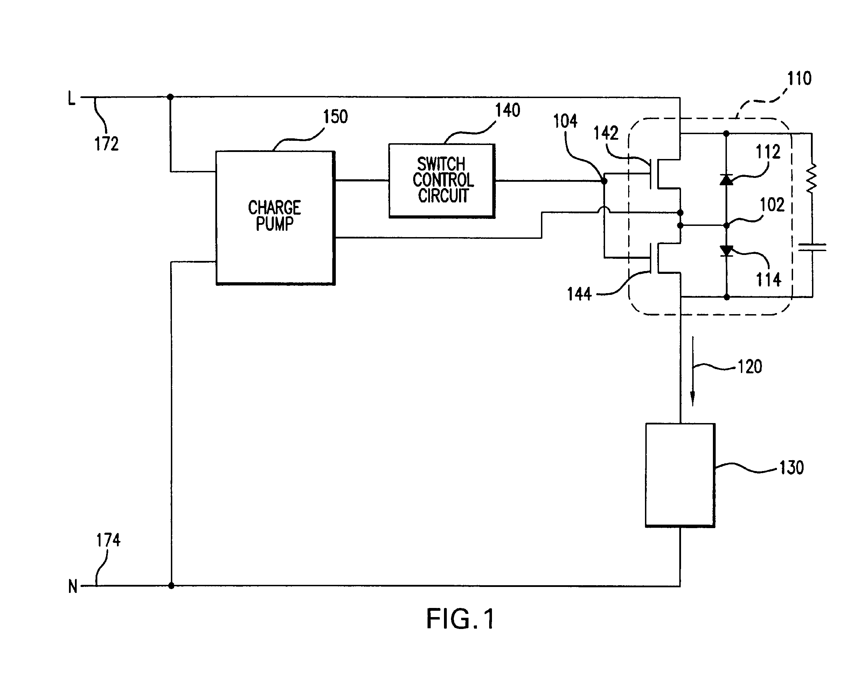

Refer now to FIG. 1 wherein an AC MOSFET switch **110,** including anti-parallel diodes **112 114**, is illustrated, in accordance with one embodiment. For the MOSFETs **142 144** illustrated, the sources of the MOSFET devices are coupled at junction **102**. In one embodiment, MOSFETs **142 144** are power MOSFETs. In addition, the gates are electrically coupled at junction **104**. These couplings are to facilitate the operation of the two MOSFETs **142 144** as a single AC MOSFET switch. Thus, by applying a gate to source voltage, $V_{GS}$, greater than the threshold voltage, $V_{TH}$, to the two MOSFETs **142 144**, both MOSFETs conduct current **120**.

Also illustrated in FIG. 1 are two diodes **112 114**. These diodes **112 114**, which may be parasitic or explicit, are anti-parallel to their respective MOSFETs. As described in further detail below, these diodes **112 114** may be utilized to bypass the intrinsic anti-parallel diodes of the MOSFETs. Thus, as illustrated, the anodes of the diodes **112 114** are coupled to the sources of the diodes' respective MOSFET and the cathodes are coupled to the respective drains.

FIG. 1 also illustrates the AC MOSFET switch in use in controlling power to a load. As previously mentioned, AC MOSFET switch **110** comprises two MOSFETs **142 144.** AC MOSFET switch **110** controls current **120** through load **130**. This may be accomplished by switch control circuit **140** which applies the gate-source voltages for the two MOSFETs **142 144** forming the AC MOSFET switch **110.** In the embodiment illustrated, charge pump biasing circuit **150** supplies current to switch control circuit **140** from line (L) **172** and neutral (N) **174** connections of the AC power source.

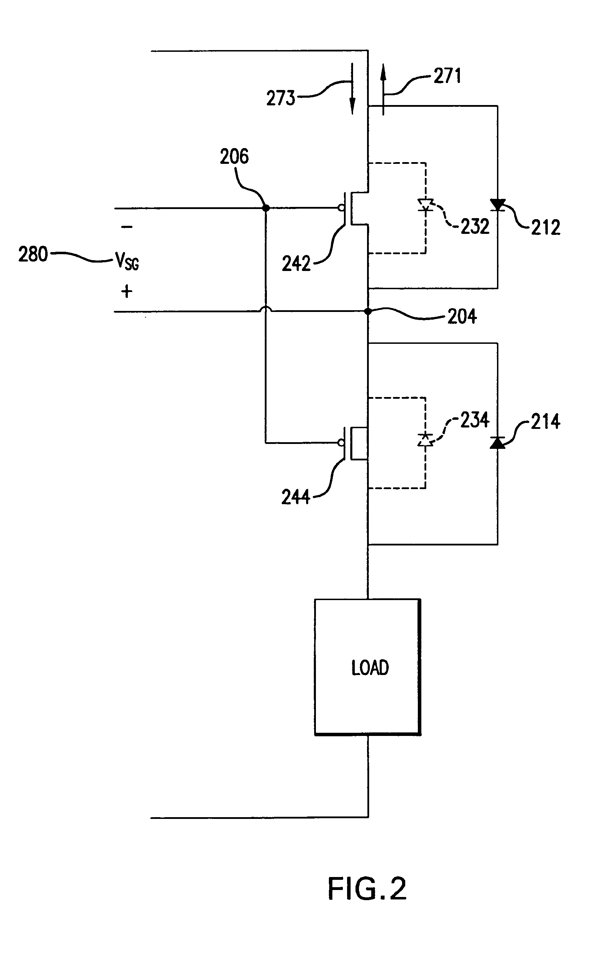

FIG. 2 illustrates a more detailed look at an AC MOSFET switch, utilizing P type MOSFETs, including intrinsic parasitic diodes **232 234** of the MOSFETs **242 244,** in accordance with one embodiment. Also illustrated are antiparallel diodes **212 214** which may be utilized to bypass the intrinsic anti-parallel diodes **232 234** of the MOSFETs. Note that the sources of both MOSFETs **242 244** are coupled **204** to each other. In addition, the gates of both MOSFETs **242**

**244** are coupled **206** to each other. When a voltage, $V_{SG}$ **280** less than a threshold voltage $V_{TH}$ is applied, the MOSFETs **242 244** will be "turned-off" and the internal reverse biased PN junctions will substantially prevent current from flowing through the MOSFETs.

When a voltage, $V_{SG}$ **280** greater than a threshold voltage $V_{TH}$ is applied to the common sources and gates of MOSFETs **242 244** are turned on to facilitate the flow of current through the AC MOSFET switch. Note that current will flow in the reverse direction in MOSFET **242** or **244** depending on the polarity of the AC voltage source. That is, in the reverse direction as is normally used in DC circuits, that is drain to source in an N type MOSFET or source to drain in a P type MOSFET. The reverse current flow causes no problem as the MOSFET transistor is truly a bidirectional device, that is, current may flow from drain to source or source to drain once the proper gate voltage is applied and the conductive channel forms. Normally, during reverse polarity across the source/drain of a MOSFET, an internal PN junction, represented by parasitic diodes **234** and **232** in FIG. 2, will eventually turn on allowing current **271** to flow. Note that parasitic diodes **234** and **232** are not separate from the MOSFET **244** and **242**; e.g. parasitic diode **234** is a PN junction that is part of the structure of transistor **244**. Once the gate voltage is removed the parasitic diode conducts during reverse current flow which makes a single MOSFET unsuitable for the control of alternating current **271 273.** The common source configuration of MOSFET **242** and **244** of Fig. 2 results in one of the parasitic diodes in a reverse biased state which substantially prevents current flow through the parasitic diodes **232 234** when the MOSFETs are in either the conducting or nonconducting states.

Referring again to FIG. 1, switch control circuit **140** and charge pump circuitry 150 are utilized to provide control for the application of the voltage to the gates of MOSFETs **142 144**. In the embodiment illustrated, switch control circuit **140** may be an externally controlled pulse width modulation circuit. In the embodiment illustrated, charge pump **150** utilizes the AC line to power the pulse width modulation circuitry. In addition, the frequency of the modulated control signal may be fixed, whereas the duty cycle of the modulation, as described below, is utilized to determine the power to be delivered to the load **130.** In an alternative embodiment the gate and source of the AC MOSFET may be driven by a circuit which has a minimum conduction time combined with a variable frequency to determine the power to be delivered to the load **130**.

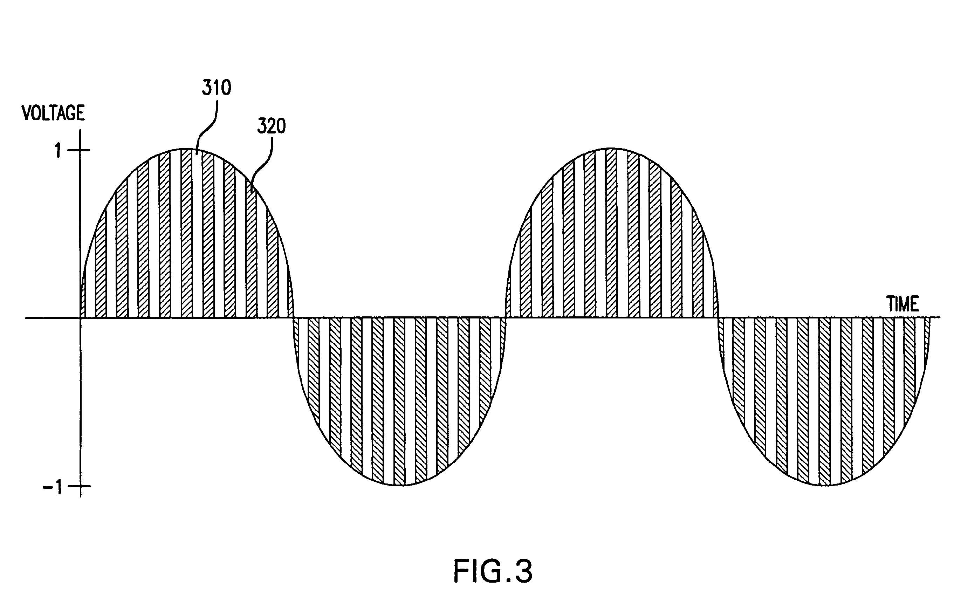

FIG. 3 illustrates current that is delivered to a load when one embodiment of the AC MOSFET switch is utilized to control current. For example, as discussed above with respect to Figure 1, the switch control circuit **140** may be a pulse width modulation circuit. In such a case, the power delivered to the load **130** can be controlled by changing the duty cycle of the pulse control signal. FIG. 3 illustrates an example input voltage **310** from the line and neutral. Illustrated also, in the dark shaded regions **320**, are the periods where the AC MOSFET switch **110** is switched on to allow current to flow through the load **130**. The voltage **310** and current **320** are normalized so that they share a common envelope. Thus, in the illustrated embodiment, a 50% duty cycle signal driving the gate to source voltage will result in an effective power of one half the total power available being delivered the load. By utilizing a pulse width modulation technique, the level of power delivered to the load can be adjusted by controlling the width of the pulses generated by the pulse width modulation of the switch control circuit. The equation governing the power transfer to the load is:

$$Pavg = \frac{Vrms^2}{R} \cdot d.$$

Where $V_{rms}$ is the Root Mean Square (rms) voltage of the AC power source, R is the resistance of the load and d is the duty ratio of the pulse width modulator driving the AC MOSFET. By inspection of this equation, the power transferred to the load is a linear function of the duty ratio of the pulse width modulator. The load is at zero power when the duty ratio is zero and at maximum power when the duty ratio is 1.

In an alternative embodiment in which the gate and source of the AC MOSFET switch are driven by a circuit which has a minimum conduction time combined with a Variable Frequency Oscillator (VFO) the power delivered to the load 130 is determined by

$$P = V^2 \div R \times f \times T_{min}$$

Where V is the rms voltage of the AC power source, R is the resistance of the load, f the frequency of the VFO driving the AC MOSFET and $T_{min}$ the minimum conduction time allowed. By inspection, this equation shows that the power transferred to the load is a linear function of the frequency of the VFO. The load is at zero power when the VFO frequency is 0 and at maximum power when the period of the frequency of the VFO is equal to or less than the minimum allowed conduction time $T_{min}$.

The above examples operate to facilitate the switching of the alternating current at relatively higher frequencies. There are advantages to switching the current at relatively higher frequencies. Switching frequencies out of the audio range (e.g. greater than 20 KHz) can be utilized to reduce human factor issues associated with audible switching noise. Another advantage of operation at higher frequencies may be a reduction in switching and conduction losses. Implementations operating at significantly lower frequencies spend more time in the linear region of operation. Spending more time in the linear region during switching may dissipate significant amounts of additional energy in the form of heat as relatively slow transitions are made through this linear region. In addition, because of the relatively low voltage drops associated with the disclosed switching of alternating current, less energy is dissipated from the product of the current flowing across the voltage drops of the devices. In addition, the AC MOSFET switching circuit above does not introduce significant harmonics into the alternating current. This can reduce costs associated with filtering these harmonics to meet international regulatory requirements.

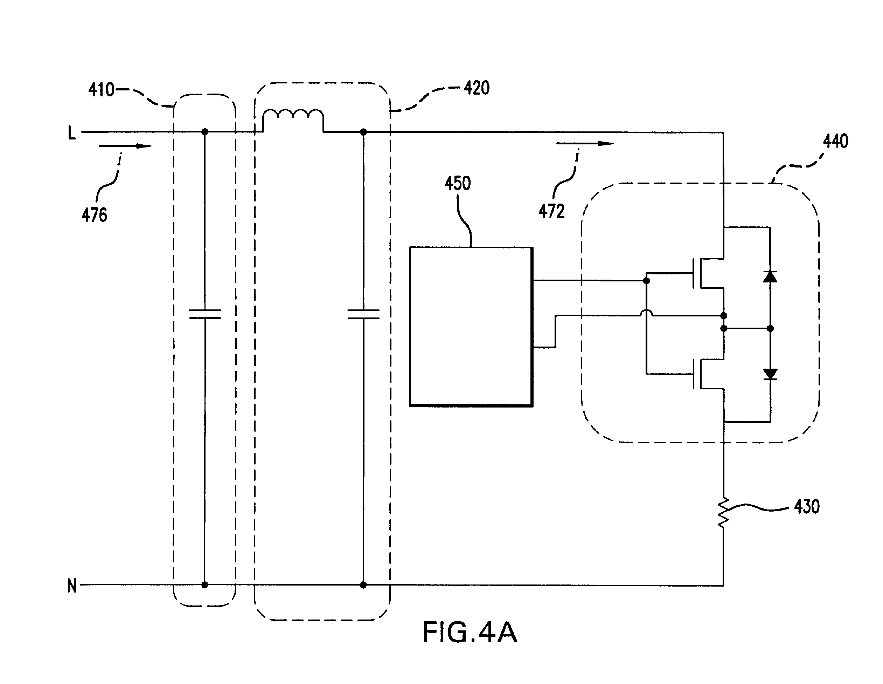

FIG. 4A illustrates input circuitry for an AC MOSFET switch, in accordance with one embodiment. Illustrated is a filter stage **410** to provides a high frequency short to ground to any transients or conducted emissions that occur across the inputs. Illustrated also is a filtering stage **420** to provide smoothing of the alternating current drawn by the load **430**. The effect of this filter is to smooth the harmonic rich current drawn by the pulse width modulated, or VFO driven load, such that the power source experiences a continuous current flow with virtually no harmonic current content.

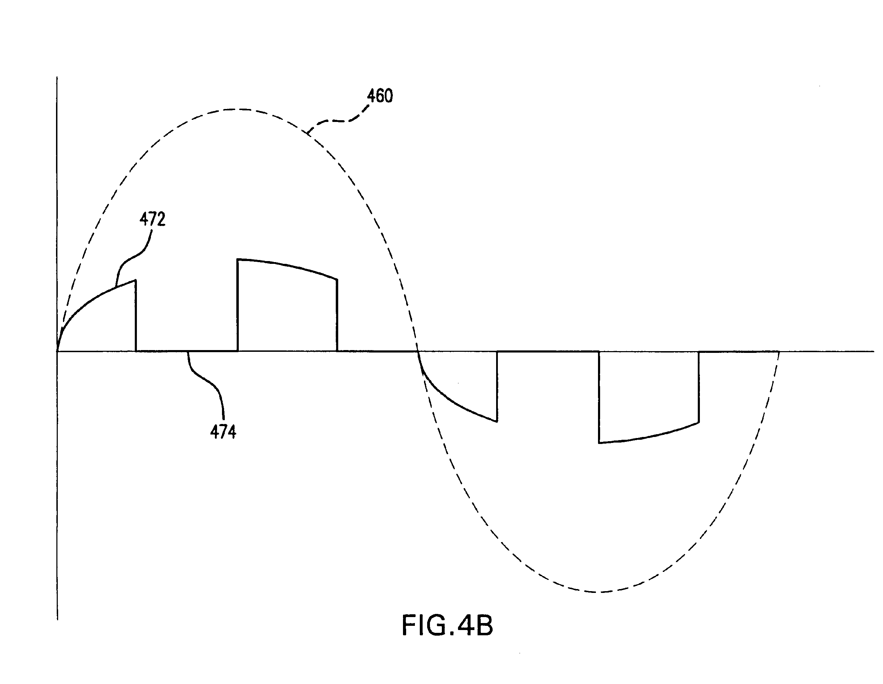

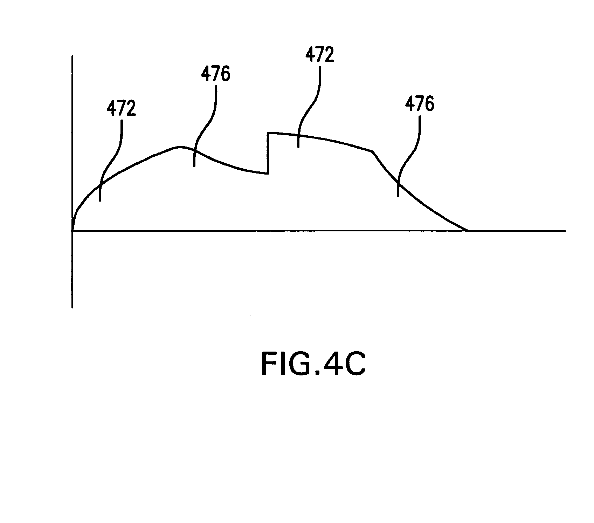

In the embodiment, switch control circuit **450** switches the current **472** delivered to the load as illustrated in FIG. 4B. During times of switching, assuming a purely resistive load, the current **472** through the load **430** will follow the line voltage provided, that is, it will be in phase. When the switch is turned off, the current delivered to the load will drop to zero **474**. Thus, as can be seen there will be dramatic shifts or steps in the current drawn by the load as the switch turns on and off. These step changes in the current represent unwanted current harmonics placed on the AC power source which may exceed regulatory limits. To solve this problem, filtering stage **420** is added to the circuit. FIG. 4C illustrates the current drawn from the AC power source at the line and neutral connections by the switched load as a result of the filtering stage **420**. When the switch is turned off, the filtering stage **420** smoothes current **476** drawn by the load **430**. In the case in which the switch is driven by a pulse width modulator, the total instantaneous current drawn by the circuit may be the sum of the fundamental current and the instantaneous value of the ripple current. This instantaneous current may be expressed as

$$i_L(t) = \frac{V \cdot d}{R} \cdot \sin(2 \cdot \pi \cdot f_o \cdot t) + \frac{\pi^2}{4} \cdot (1 - d) \cdot \left(\frac{f_c}{f_s}\right)^2 \cdot \frac{V \cdot d}{R} \cdot \sin(2 \cdot \pi \cdot f_o \cdot t) \cdot \sin(2 \cdot \pi \cdot f_s \cdot t).$$

where $f_c$ is the resonant frequency of filtering stage **420**, $f_s$ is the switch frequency of the pulse width modulator, $f_o$ is the frequency of the AC power source, d is the duty cycle of the pulse width modulator, V is the peak source voltage, and R is the load resistance **430**. Under direct examination of this equation it is noted that, as the switch frequency of the pulse width modulator is increased, the resultant alternating current waveform at the Line and Neutral connections smoothes dramatically.

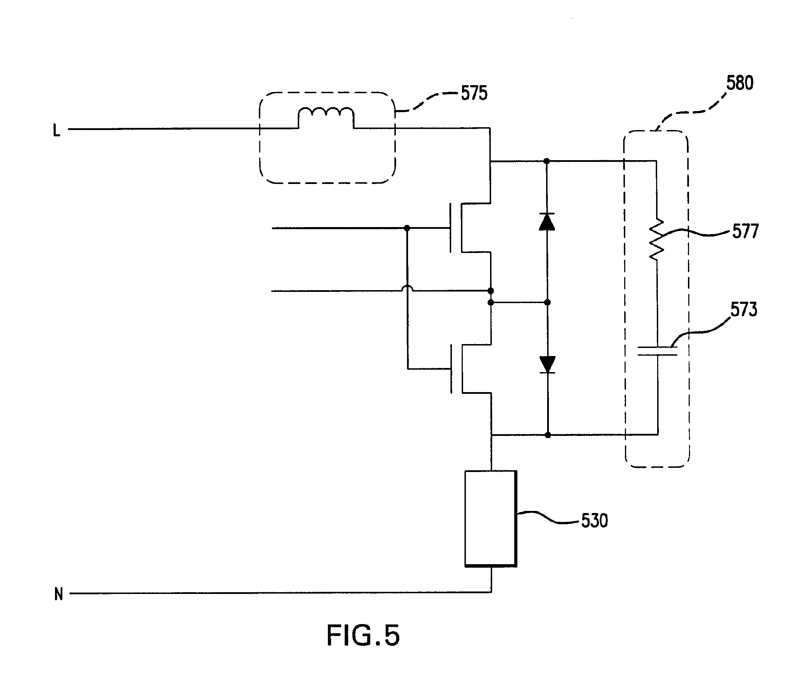

FIG. 5 illustrates an AC MOSFET switch design including a snubbing device **580,** in accordance with one embodiment. Snubbing device **580** is utilized for dissipating energy stored in the circuit. Stored energy in a circuit exists due to various factors associated with the circuit such as: parasitic inductance associated with the wiring providing the AC current, parasitic inductance in the components leads, and inductance in the load itself. Snubber designs are designed to capture a portion of the stored energy in a circuit, when the circuit is switched off. These snubber designs are to reduce, among other things, the resonance of the circuit. However, these snubber designs are not engineered to dissipate all the energy; they are simply designed to dissipate enough energy to reduce resonance and the resulting resonant "over" voltages that may otherwise occur.

To dissipate all the energy in the circuit, a significantly larged sized capacitor **573** may be used in snubber **580** design. It is desirable to have the resistance **577** approximately match the resistance in the load 530. Thus, if the load resistance is approximately 20 ohms, then the resistance of the snubber should be selected to be about 20 ohms. In addition, the stored inductance **575** for a typical circuit driving the AC MOSFET switch has been measured at approximately 100 nanoHenries. In some snubber designs, a capacitor capable of capturing about 1/5 of the energy stored in the inductive parasitics may be utilized. As mentioned, this capacitor size is utilized to simply avoid resonance of the circuit. However, the remaining energy is dissipated via heat in the switching element or as Radio Frequency (RF) emissions. To avoid this heat or RF emissions, a larger snubber circuit may be utilized.

In order to have the snubber dissipate substantially all the stored energy of the circuit, the energy dissipated by the snubber should equal the energy stored due to the inductance of the circuit. Thus,

$$1/2 \ LI^2 = 1/2 \ CV^2, \text{ where } I = V/R$$

$$1/2 \ L(V/R)^2 = 1/2 \ CV^2$$

Solving for C we find that:

$$C = L/R^2$$

Thus, the capacitor used is directly related to the value of the parasitic inductance.

Dissipating heat may be undesirable as it may result in damage to the circuit. A solution to this may be to include a heat sink. However, the addition of the heat sink may add cost to the design. In addition, generation of RF emissions may be undesirable as it may result in poor classification during RF certification proceedings for the device containing the AC MOSFET switch. To protect from RF emissions, a shield for the RF emissions may be provided. Again, however, the addition of a shield may add cost to the design.

Thus, in one embodiment, the capacitor that is part of the snubber illustrated in FIG. 5 is designed to capture substantially all of the stored energy in the circuit associated with the AC MOSFET switch. In this manner, the design of RF shield and the design of any heat dissipating devices may be reduced.

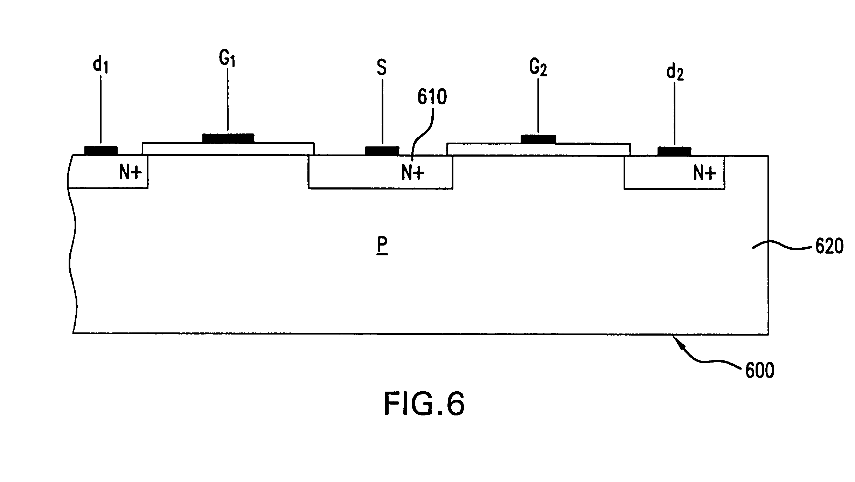

FIG. 6 illustrates a single integrated circuit (IC) device **600** containing two NMOS type MOSFET devices of an AC MOSFET switch, in accordance with one embodiment. In an alternative embodiment, two PMOS type MOSFET devices may be utilized in the construction of an AC MOSFET switch. Recall that the two sources from the two MOSFETs are logically coupled to each other in the AC MOSFET switch. By fabricating the two MOSFETs in a single package on an IC, the two MOSFETs may share a common source region **610** on the IC. In the embodiment illustrated in FIG. 6, a common source region **610** is implanted into the die containing the AC MOSFET switch. The sharing of the common source region 610 may allow the use of a single source lead emanating from the package containing the two MOSFETs of AC MOSFET switch. This, in turn, may result in decreased conduction resistance due to the elimination of one source lead and the source lead's associated wire bonding parasitics, such as ohmic resistance from the die to a package lead. For example, in one embodiment, the elimination of one of the source leads may reduce the impedance by 70 milliohms, corresponding to the impedance associated with one of the leads to the AC MOSFET switch.

70 milliohms may be a substantial portion of the overall resistance associated with the AC MOSFET switch. For example, assume an $R_{DSON}$ of 100 milliohms for each MOSFET in the AC MOSFET switch. Thus, with a 70 milliohm resistance for each lead for the source and drain, the overall path impedance across the source and drain is 240 milliohms. Two discrete series devices have an effective resistance through the AC MOSFET switch of 480 milliohms. Recall that the external source lead in the AC MOSFET is used for the application of gate bias and as a conduction path for certain types of snubber applications during switch turn off. By design the external source connection 610 has very low current flow and does not introduce series resistance to the AC MOSFET switch when the switch is conducting. This fact allows the conduction resistance of the AC MOSFET switch to be reduced by 140 milliohms, or a reduction in effective resistance 30% by using a common source region on the die of the AC MOSFET and the elimination of one lead. Since the power dissipated is directly related to the resistance, this results in a 15% reduction in power loss, for the embodiment described. Fabrication of the AC MOSFET switch on a single die also allows one of the gate terminals of the discrete implementation to be eliminated. The result of the common source region and eliminated gate terminal is a four pin device with two high current drain connections and two lower current gate and source connections. One pin of the four pin device is coupled to each of the gates of the two MOSFETs. Another pin is coupled to the common source region , and each of the two remaining pins are coupled to a different one of the drains.

Thus, embodiments of an AC MOSFET switch design have been disclosed. This design generally allows for faster operation of the AC MOSFET switch to, among other things, allow operation significantly above the audio frequency spectrum (e.g. greater than 20kHz). The AC MOSFET switch operation generally utilizes higher frequencies which, in turn, allows the device to be used in a broad range of AC power control, thus reducing the use of rectification and the resulting induction of harmonics to the power line. These advantages reduce the use of expensive filtering and allow for better operation in environments containing persons such as the home or office environment. The designs may also allow for single IC design of the AC MOSFET switch in many applications. This may reduce the number terminal thus reducing loss due to lead resistance.

**Claims**

1. An alternating current switching circuit (110) comprising:

   a first Field Effect Transistor (FET) (142) having a first source, a first gate and a first drain;
   a second FET (144) having a second drain, a second source coupled to said first source and a second gate coupled to said first gate;
   a first diode (112) having a first anode coupled to said first source and a first cathode coupled to said first drain; and
   a second diode (114) having a second anode coupled to said second source and a second cathode coupled to said second drain.

2. The device of claim 1 wherein said first FET and said second FET are N type MOSFETs.

3. An alternating current switching circuit comprising:

   a first Field Effect Transistor (FET) (244) having a first source, a first gate and a first drain;
   a second FET (242) having a second drain, a second source coupled to said first source and a second gate coupled to said first gate;
   a first diode (234) having a first anode coupled to said first drain and a first cathode coupled to said first source; and
   a second diode (232) having a second anode coupled to said second drain and a second cathode coupled to said second source.

4. The device of claim 3 wherein said first FET and said second FET are P type MOSFETs.

5. A device comprising:

   an alternating current switching circuit (440) including:

   a first Field Effect Transistor (FET) having a first source, a first gate and a first drain,
   a second FET having, a second drain, a second source coupled to said first source and a second gate coupled to said first gate,
   a first diode having a first anode coupled to said first source and a first cathode coupled to said first drain; and
   a second diode having a second anode coupled to said second source and a second cathode coupled to said second drain; and

   a switch control circuit (450) coupled to said first gate and said second gate and coupled to said first source and said second source, said switch control circuit to facilitate operation of said alternating current switching circuit at frequencies greater than 200 Hz.

6. The apparatus of claim 5 further comprising a load coupled to said alternating current switching circuit, wherein said switch control circuit facilitates pulse width modulation of current through said load.

7. The apparatus of claim 5 wherein said switch control circuit is configured to operate said alternating current switching circuit at frequencies greater than 20 kHz.

8. In an integrated circuit, an alternating current switching circuit comprising:

   a first Field Effect Transistor (FET) having a first gate, a first drain, and a common source;
   a second FET having a second gate, a second drain and said common source;
   a first diode having a first anode coupled to said common source and a first cathode coupled to said first drain; and
   a second diode having a second anode coupled to said common source and a second cathode coupled to said second drain.

9. The alternating current switching circuit of claim 8 wherein said first gate is coupled to said second gate.

**10.** In an integrated circuit, a method of switching alternating current comprising:

receiving alternating current (AC) from a source; and
applying said alternating current across drains of two MOSFET devices of a switch, where the two MOSFET device having a common source region, and their gates are coupled together, and the switch further having diodes that are antiparallel to each MOSFET device, flowing said alternating current though said common source region.

FIG.1

EP 1 557 948 A1

FIG.2

FIG.3

EP 1 557 948 A1

FIG.4A

FIG.4B

472    476    472    476

FIG.4C

FIG.5

EP 1 557 948 A1

FIG.6

**European Patent Office**

## EUROPEAN SEARCH REPORT

Application Number

EP 04 01 7410

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 259 306 B1 (BR&UUML ET AL) 10 July 2001 (2001-07-10) | 1-4,8-10 | H03K17/041 H03K17/0412 |
| A | * column 1, lines 4-63; figures 1a-c,3 * * column 5, line 25 - line 36 * ----- | 5-7 | |
| X | DE 195 48 612 A1 (ROBERT BOSCH GMBH, 70469 STUTTGART, DE) 26 June 1997 (1997-06-26) * column 2, line 67 - column 5, line 1; figures 1-5 * ----- | 1,2,8,9 | |
| X | US 5 583 384 A (HENRY ET AL) 10 December 1996 (1996-12-10) * column 3, line 54 - column 7, line 7; figures 1,2,4 * ----- | 1,2,8 | |

TECHNICAL FIELDS
SEARCHED (Int.Cl.7)

H03K

The present search report has been drawn up for all claims

| Place of search | Date of completion of the search | Examiner |
|---|---|---|
| Munich | 5 April 2005 | Jonda, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 01 7410

This annex lists the patent family members relating to the patent documents cited in the above-mentioned European search report.
The members are as contained in the European Patent Office EDP file on
The European Patent Office is in no way liable for these particulars which are merely given for the purpose of information.

05-04-2005

| Patent document cited in search report | | Publication date | Patent family member(s) | | Publication date |
|---|---|---|---|---|---|
| US 6259306 | B1 | 10-07-2001 | CN | 1285657 A | 28-02-2001 |
| | | | EP | 1079525 A1 | 28-02-2001 |
| | | | JP | 2001111403 A | 20-04-2001 |
| | | | SG | 83808 A1 | 16-10-2001 |
| | | | TW | 465184 B | 21-11-2001 |
| DE 19548612 | A1 | 26-06-1997 | NONE | | |
| US 5583384 | A | 10-12-1996 | NONE | | |

EPO FORM P0459